Europäisches Patentamt

European Patent Office

Office européen des brevets

(11) Numéro de publication: **0 302 562 B1**

# FASCICULE DE BREVET EUROPEEN

(45) Date de publication de fascicule du brevet: **30.09.92**     (51) Int. Cl.⁵: **H03L 7/08**

(21) Numéro de dépôt: **88201628.0**

(22) Date de dépôt: **28.07.88**

---

(54) **Synthétiseur de fréquences présentant un dispositif indicateur d'accord.**

---

(30) Priorité: **29.07.87 FR 8710726**

(43) Date de publication de la demande:
**08.02.89 Bulletin 89/06**

(45) Mention de la délivrance du brevet:
**30.09.92 Bulletin 92/40**

(84) Etats contractants désignés:
**DE FR GB IT**

(56) Documents cités:
**GB-A- 2 180 708**
**US-A- 4 232 393**
**US-A- 4 473 805**
**US-A- 4 584 537**

**PATENT ABSTRACTS OF JAPAN, vol. 10, no.
113 (E-399)[2170], 26 avril 1986, page 7 E 399;
JP-A-60 247 330 (MITSUBISHI DENKI K.K.)
07-12-1985**

(73) Titulaire: **PHILIPS COMPOSANTS
117, quai du Président Roosevelt
F-92130 Issy les Moulineaux(FR)**

(84) Etats contractants désignés:
**FR**

(73) Titulaire: **N.V. Philips' Gloeilampenfabrieken**

Groenewoudseweg 1
**NL-5621 BA Eindhoven(NL)**

(84) Etats contractants désignés:
**DE GB IT**

(73) Titulaire: **PLESSEY OVERSEAS LIMITED
Vicarage Lane
Ilford Essex IG1 4AO(GB)**

(84) Etats contractants désignés:
**DE FR GB IT**

(72) Inventeur: **Cowley, Nicolas Paul
Société civile S.P.I.D. 209 rue de l'Université
F-75007 Paris(FR)**
Inventeur: **Walbrou, Pascal
Société civile S.P.I.D. 209 rue de l'Université
F-75007 Paris(FR)**

(74) Mandataire: **Charpail, François et al
Société Civile S.P.I.D. 156, Boulevard Haussmann
F-75008 Paris(FR)**

---

EP 0 302 562 B1

## Description

La présente invention a pour objet un synthétiseur de fréquences comportant au moins un oscillateur commandé en fréquence par un signal d'accord et délivrant un signal de fréquence d'accord, des moyens pour générer un signal de fréquence de référence, un détecteur de phase recevant le signal de fréquence d'accord et le signal de fréquence de référence, un circuit de boucle à verrouillage de phase recevant en entrée des signaux produits par le détecteur de phase et produisant en sortie ledit signal d'accord, et un dispositif indicateur d'accord, présentant une marge de tolérance sur la différence de phase entre le signal de fréquence d'accord et le signal de fréquence de référence.

Un tel synthétiseur de fréquences est connu du brevet US-A-4473805 (RCA Corp.). Dans celui-ci, le signal de fréquence d'accord est obtenu après division de fréquence et le détecteur de phase comprend également le circuit de boucle à verrouillage de phase.

Le dispositif indicateur d'accord est conçu de manière à produire une alarme en cas de perte de verrouillage de phase. Il comporte une porte OU EXCLUSIF recevant à une entrée le signal de référence retardé par un premier retard réglable en fonction des rapports cycliques des signaux et à une autre entrée le signal de fréquence d'accord.

La sortie de la porte OU EXCLUSIF attaque d'une part l'entrée d'une porte ET après avoir été décalé d'un deuxième retard réglable et d'autre part attaque directement l'autre entrée de cette porte. Le deuxième retard réglable permet de choisir une marge de tolérance sur la différence de phase au delà de laquelle l'alarme se déclenche.

Ce dispositif indicateur d'accord présente l'inconvénient de dépendre des rapports cycliques relatifs des signaux, ce qui nécessite un réglage particulier du premier retard pour les différents rapports cycliques et les différentes fréquences de fonctionnement (voir aussi le US-A-4 232 393).

La présente invention a pour objet un synthétiseur présentant un dispositif indicateur d'accord susceptible de fonctionner quels que soient les rapports cycliques des signaux reçus, et dans une gamme de fréquences étendue, sans qu'aucun réglage dépendant de ces paramètres soit nécessaire, et qui soit intégrable, c'est-à-dire sans nécessiter de composants extérieurs.

Dans ce but, le synthétiseur de fréquences selon l'invention est caractérisé en ce que le détecteur de phase est agencé de manière à produire en sortie un premier et un deuxième signal de phase respectivement d'avance et de retard de phase entre le signal de fréquence d'accord et le signal de fréquence de référence, le circuit de boucle à verrouillage de phase recevant lesdits premier et deuxième signaux de phase, et en ce que le dispositif indicateur d'accord comporte un premier circuit logique produisant en sortie un premier signal logique constitué par le produit logique du premier signal de phase retardé d'un temps donné par un premier circuit retardateur et du premier signal de phase, un deuxième circuit logique produisant en sortie un deuxième signal logique constitué par le produit logique du deuxième signal de phase retardée du même temps donné par un deuxième circuit retardateur et du deuxième signal de phase, un troisième circuit logique produisant en sortie un troisième signal logique constitué par l'addition logique du premier et du deuxième signal logique, et un registre recevant ledit signal de fréquence de référence et ledit troisième signal logique et produisant en sortie un signal d'indication d'accord, le registre étant agencé de manière que le niveau du signal d'indication d'accord corresponde à un accord seulement si le troisième signal logique présente un niveau indiquant un accord stable pendant au moins deux périodes successives de la fréquence de référence.

Selon un mode de réalisation préféré, le détecteur de phase comporte une première et une deuxième bascule de détection de type D recevant un niveau logique haut sur leur entrée de donnée et recevant à leur entrée de cadencement respectivement le signal de fréquence d'accord et le signal de fréquence de référence, la sortie non inverseuse de la première et de la deuxième bascule de détection délivrant respectivement le premier et le deuxième signal de phase et l'entrée de remise à zéro de la première et de la deuxième bascule de détection recevant le produit logique du premier et du deuxième signal de phase.

Le registre peut comporter un diviseur de fréquence dont l'entrée de cadencement reçoit l'inverse du signal de fréquence de référence, et produit un signal de cadencement qui est un sous-multiple de la fréquence de référence, lequel attaque l'entrée de cadencement d'une bascule d'acquisition d'accord de type D dont l'entrée de donnée reçoit un niveau logique bas, dont l'entrée de mise à niveau (set) reçoit le troisième signal logique et en ce qu'il comporte une première bascule de confirmation d'accord, de type D, dont l'entrée de remise à zéro reçoit le signal de la sortie non-inverseuse de la bascule d'acquisition d'accord et dont l'entrée de donnée reçoit le signal de la sortie inverseuse de la bascule d'acquisition d'accord, et dont l'entrée de cadencement reçoit ledit signal de cadencement.

Selon une variante avantageuse, le registre est un registre à décalage qui comporte n bascules de confirmation d'accord, avec n entier supérieur à 1, remises à zéro par le signal de sortie non-inverseuse de la bascule d'acquisition d'accord et recevant à leur entrée de cadencement ledit signal de cadencement, l'entrée de donnée de la p$^{ième}$ bascule de confirmation d'accord recevant le signal de la sortie non-inverseuse de la (p-1$^{ième}$) bascule de confirmation d'accord, la sortie de la n$^{ième}$ bascule de confirmation d'accord délivrant ledit signal d'accord.

L'invention sera mieux comprise à la lecture de la description qui va suivre donnée à titre d'exemple non limitatif en liaison avec les figures qui représentent :

- la figure 1, un schéma d'un synthétiseur de fréquences selon l'invention.
- les figures 2a et 2b, un mode de réalisation du détecteur de phase et de la boucle de verrouillage de phase d'un synthétiseur selon l'invention, et un chronogramme de signaux caractéristiques
- les figures 3a et 3b un mode de réalisation du dispositif indicateur d'accord d'un synthétiseur selon l'invention, et les chronogrammes de signaux caractéristiques.

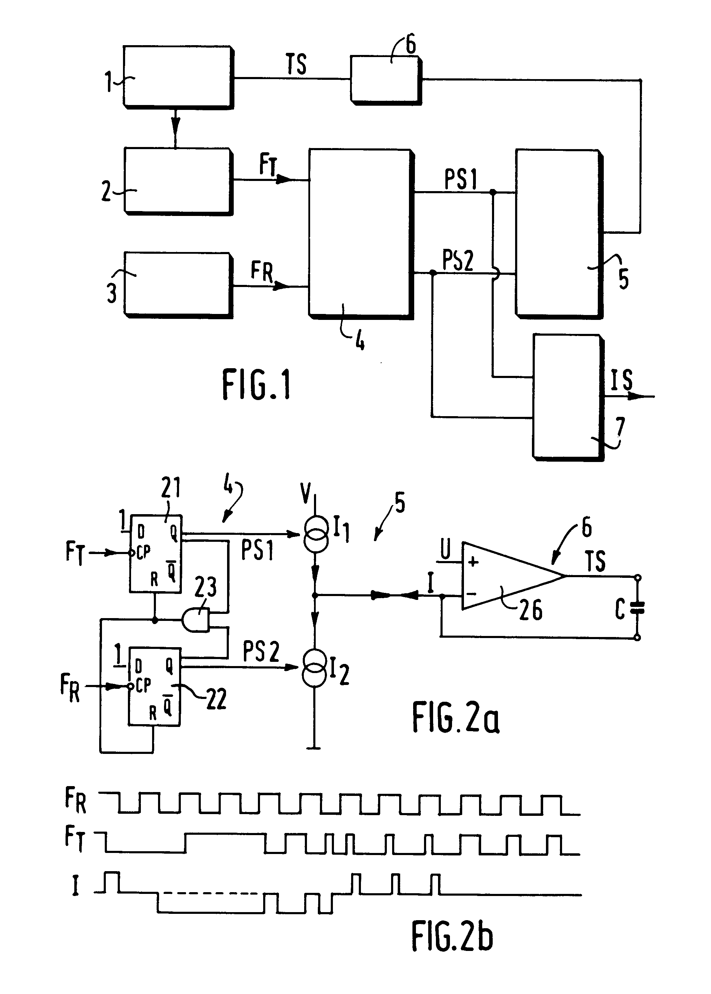

Selon la figure 1, un synthétiseur selon l'invention comporte un oscillateur commandé en tension 1, dont la fréquence des signaux de sortie est divisée par un diviseur programmable 2 dont la sortie fournit un signal de fréquence d'accord $F_T$ introduit à une entrée d'un détecteur de phase 4 dont l'autre entrée reçoit un signal de fréquence de référence $F_R$ produit par un générateur de fréquence 3 comprenant par exemple un oscillateur de référence et un diviseur de fréquence dans un rapport fixe. Le diviseur de fréquence programmable 2 a pour fonction de permettre l'accord du synthétiseur sur une large gamme de fréquences pour des applications à des téléviseurs ou à des récepteurs radio, le cas échéant selon plusieurs gammes de fréquences. Dans ce dernier cas, le synthétiseur peut comporter plusieurs oscillateurs commandés en tension, entre lesquels une commutation est opérée pour les différentes gammes de fréquences.

Le détecteur de phase 4 produit en sortie deux signaux de phase respectivement d'avance PS1 et de retard PS2 entre le signal de fréquence d'accord $F_T$ et le signal de référence $F_R$. Ces signaux PS1 et PS2 sont utilisés dans une boucle à verrouillage de phase comprenant un préamplificateur de charges 5 et un amplificateur de bouclage 6 produisant à sa n signal d'accord TS dont la tension détermine la valeur de la fréquence de l'oscillateur variable 1.

Un dispositif indicateur d'accord 7 reçoit à ses entrées les deux signaux de phase PS1 et PS2 et produit en sortie un signal d'indication d'accord IS.

Selon les figures 2a et 2b, le signal de fréquence d'accord $F_T$ est introduit à l'entrée de cadencement CP d'une bascule dite de détection, de type D, 21 et le signal de fréquence de référence est introduit à l'entrée de cadencement CP d'une bascule dite de détection, de type D, 22. Les sorties non inverseuses Q des bascules 21 et 22 fournissent les signaux respectivement PS1 et PS2. Une porte ET 23 reçoit à ses entrées les signaux PS1 et PS2 et sa sortie est connectée aux entrées de remise à zéro R des bascules 21 et 22. Ce circuit (21,22, 23) constitue un détecteur de phase à mémoire. Les signaux PS1 et PS2 sont utilisés pour commander l'une ou l'autre de deux sources de courant commandables $I_1$ et $I_2$ de même intensité et agissant en sens contraires (constituant un préamplificateur de charges 5) pour délivrer un courant $I = (I_1 - I_2)$ à l'entrée inverseuse d'un amplificateur 26 contre-réactionné par un condensateur C, constituant ainsi un amplificateur de charge 6, et délivrant en sortie le signal d'accord TS. Les chronogrammes des signaux $F_R$, $F_T$, et I sont montrés à la figure 2b. Lorsque $F_T$ est en avance sur $F_R$, le signal I a une valeur $I_1$ pendant un intervalle de temps correspondant à l'écart de phase. Par contre, lorsque $F_T$ est en retard sur $F_R$, le signal I a une valeur $-I_1 = -I_2$ pendant un intervalle de temps correspondant à l'écart de phase. De la sorte, la boucle de verrouillage de phase tend vers un écart de phase nul, donc à un accord entre $F_T$ et $F_R$ à la fois sur la fréquence et sur la phase.

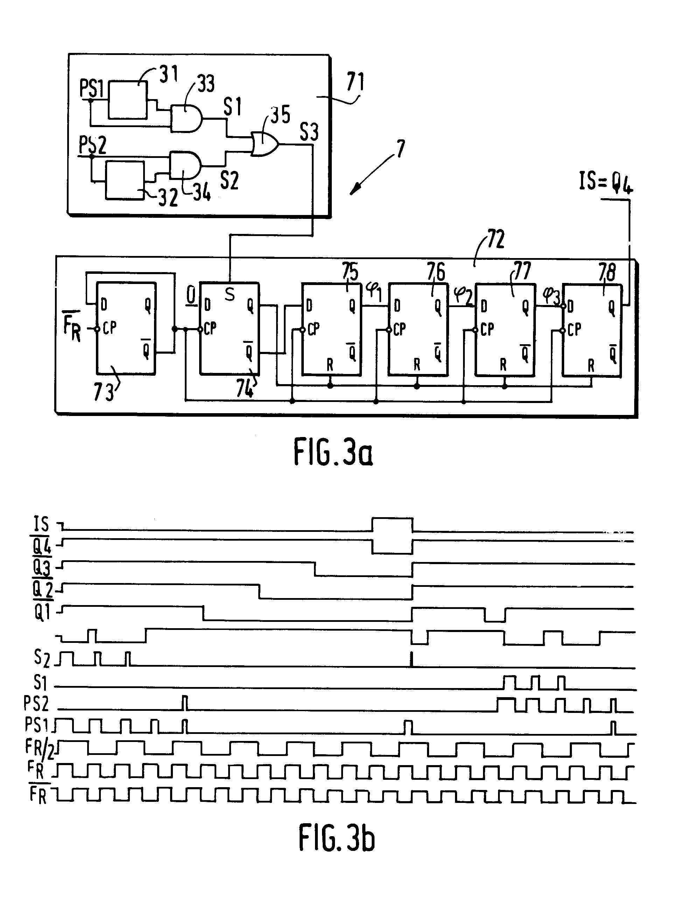

Selon les figures 3a et 3b, le signal d'indication d'accord IS est obtenu à partir des signaux PS1 et PS2 représentant respectivement une avance et un retard de phase entre $F_T$ et $F_R$. Le signal PS1 est introduit à une entrée d'une porte ET 33 et à l'entrée d'un circuit retardateur 31 dont la sortie attaque l'autre entrée de la porte ET33. Le signal PS2 est introduit à une entrée d'une porte ET34 et à l'entrée d'un circuit retardateur 32 dont la sortie attaque l'autre entrée de la porte ET34. Les sorties des portes ET 33 et 34 attaquent les entrées d'une porte OU35 dont la sortie délivre un signal $S_3$ représentant la condition de phase instantanée du synthétiseur par rapport à un niveau d'écart de phase accepté et déterminé par les retards, de préférence identiques, introduits par les circuits retardateurs 31 et 32. Un circuit retardateur peut être par exemple constitué par un nombre pair d'amplificateurs inverseurs de gain unité, disposés en série.

On remarquera qu'un circuit logique associant deux portes ET dont les sorties attaquent une porte OU a déjà été mise en oeuvre pour réaliser un indicateur d'accord, en l'occurence un indicateur de perte de verrouillage ou de non-verrouillage. Ce circuit a fait l'objet d'une publication dans Electronic Design 13 (8 nov.1965) pp.53-4.

Selon cet art antérieur, une des portes ET reçoit une fréquence de référence et la sortie inverseuse d'une bascule de détection de phase recevant à son entrée de remise à zéro la fréquence de référence et à son entrée de mise à niveau un signal à synchroniser. L'autre porte ET reçoit le signal à synchroniser et la sortie non inverseuse de la bascule précitée. Une impulsion est obtenue en sortie à chaque fois que se produit un décalage d'un cycle entre le signal et la fréquence de référence. Un tel circuit est donc par nature inapproprié à l'obtention d'une détection correspondant à une marge de tolérance sur la différence de phase.

Par ailleurs, le document PATENT ABSTACTS OF JAPAN, Vol. 10, n° 113 (E-399) [2170], 26 avril 1986, page 7 E 399; JP-A-60 247 330 (MITSUBISHI DENKI K.K.), 07-12-1985, divulgue un circuit indicateur de désaccord comportant un détecteur de phase qui commande un circuit logique dont la sortie est connectée à l'entreé d'un registre recevant aussi un signal de fréquence de référence. La structure du circuit logique y est toutefois différente de celle du circuit logique (71) du dispositif indicateur d'accord selon la revendication 1 et représenté à la Figure 3a.

En se reportant de nouveau à la figure 3a, le signal $S_3$ est introduit à l'entrée de mise à niveau S d'une bascule dite d'acquisition d'accord, de type D, référencée 74, dont l'entrée de donnée D reçoit un signal de niveau logique bas (0) et dont l'entrée de cadencement CP reçoit le signal de la sortie inverseuse $\overline{Q}$ d'une bascule de division par 2, de type D, référencée 73, dont l'entrée de cadencement CP reçoit l'inverse $\overline{F}_R$ du signal de fréquence de référence. La sortie inverseuse $\overline{Q}$ de la bascule 73 est bouclée sur son entrée de donnée D. Le registre peut comporter une ou plusieurs bascules de confirmation d'accord, de type D, référencées 75, 76, 77 et 78 dans l'exemple de la figure 3a qui concerne un registre à décalage à quatre bascules correspondant à une configuration de l'accord pendant huit cycles successifs de la fréquence de référence ainsi qu'il sera montré par la suite.

La bascule 75 reçoit à son entrée de donnée D le signal de la sortie inverseuse $\overline{Q}$ de la bascule 74 et les sorties non inverseuses des bascules 75, 76 et 77 sont connectées aux entrées de donnée D des bascules respectivement 76, 77 et 78. Le signal de la sortie inverseuse $\overline{Q}$ de la bascule 73 est introduit à l'entrée de cadencement CP des bascules 75 à 78. La sortie non inverseuse Q de la bascule 74 est connectée à l'entrée de remise à zéro R des bascules 75 à 78.

De la sorte, en se reportant maintenant au chronogramme de la figure 3b, il apparaît que les signaux $Q_1$, $Q_2$, $Q_3$ et $Q_4$ présents aux sorties non inverseuses Q des bascules respectivement 75, 76, 77 et 78 correspondent à une confirmation de l'accord pendant respectivement 2, 4, 6 et 8 cycles. Il en résulte que si on se contente d'une confirmation pendant seulement deux cycles, seule la bascule 75 doit être conservée et le signal $Q_1$ est à utiliser comme indication d'accord. Plus généralement, si au lieu de la bascule 73 on met en oeuvre un diviseur de fréquence dans un rapport n, les sorties $Q_1$, $Q_2$, $Q_3$ et $Q_4$ correspondront alors à une confirmation de l'accord pendant respectivement n, 2n, 3n et 4n cycles.

Tant que la boucle de phase n'est pas verrouillée, certaines des impulsions PS1 ou PS2 présentent une durée supérieure au retard introduit par les circuits retardateurs 31 et 32. Dès qu'une telle impulsion apparaît, le signal $S_3$ est au niveau haut pendant une durée correspondant à la différence entre la durée de l'impulsion PS1 ou PS2 et la durée du retard. La sortie non-inverseuse Q de la bascule 74 est alors mise au niveau bas 0 entraînant la remise à zéro des bascules 75 à 78.

Lorsque la boucle de phase est verrouillée ou quasi-verrouillée, c'est-à-dire tant que l'écart de phase entre $F_T$ et $F_R$ reste inférieur à l'écart toléré déterminé par les circuits retardateurs 31 et 32, le signal $S_3$ reste au niveau bas ce qui fait que la sortie non inverseuse Q de la bascule 74 se met au niveau 0 dès qu'une transition de cadencement apparaît à l'entrée CP (puisque l'entrée D de la bascule 74 reçoit en permanence un niveau 0). L'entrée D de la bascule 75 reçoit un niveau haut (1) de la sortie inverseuse $\overline{Q}$ de la bascule 74. Dans l'exemple considéré $Q_4$ atteint le niveau 1 au bout de huit cycles à la fréquence de référence à condition que la boucle soit restée verrouillée ou quasi-verrouillée pendant cet intervalle de temps.

Un signal d'indication d'accord selon l'invention est particulièrement intéressant dans la mesure où il permet de prendre en compte la durée réelle du verrouillage de la boucle de phase, augmenté seulement d'une durée très brève nécessitée par le confirmation de l'accord, de manière à éviter de prendre en compte des coïncidences fortuites entre les signaux.

Lors du chargement de fréquence d'accord d'un récepteur TV, l'indicateur d'accord selon l'invention permet de déterminer à quel moment l'accord peut être considéré comme obtenu sans attendre une durée pré-déterminée.

Lors d'une recherche automatique de station, par exemple dans un autoradio, dans lequel l'émetteur le plus puissant d'une station de radio doit être recherché, l'indicateur d'accord évite d'avoir à attendre une durée prédéterminée dans l'hypothèse où, à des fréquences prédéterminées, correspondent des accords sur des émetteurs proches ou lointains à sélectionner.

## Revendications

1. Synthétiseur de fréquences comportant au moins un oscillateur commandé en fréquence (1) par un signal d'accord et délivrant un signal de fréquence d'accord, des moyens pour générer un signal de fréquence de référence (3), un détecteur de phase (4) recevant le signal de fréquence d'accord et le signal de fréquence de référence, un circuit de boucle à verrouillage de phase (5) recevant en entrée des signaux produits par le détecteur de phase et produisant en sortie ledit signal d'accord, et un dispositif indicateur d'accord (7) présentant une marge de tolérance sur la différence de phase entre le signal de fréquence d'accord et le signal de fréquence de référence, caractérisé en ce que le détecteur de phase (4) est agencé de manière à produire en sortie un premier (PS1) et un deuxième (PS2) signal de phase respectivement d'avance et de retard de phase entre le signal de fréquence d'accord $(F_T)$ et le signal de fréquence de référence $(F_R)$, le circuit de boucle à verrouillage de phase recevant lesdits premier et deuxième signaux de phase, et en ce que le dispositif indicateur d'accord (7) comporte un premier circuit logique (31, 33) produisant en sortie un premier signal logique $(S_1)$ constitué par le produit logique du premier signal de phase retardé d'un temps donné par un premier circuit retardateur (31) et du premier signal de phase (PS1), un deuxième circuit logique (32, 34) produisant en sortie un deuxième signal logique $(S_2)$ constitué par le produit logique du deuxième signal de phase retardé du même temps donné par un deuxième circuit retardateur (32) et du deuxième signal de phase (PS2), un troisième circuit logique (35) produisant en sortie un troisième signal logique $(S_3)$ constitué par l'addition logique du premier $(S_1)$ et du deuxième $(S_2)$ signal logique, et un registre (72) recevant ledit signal de fréquence de référence $(F_R)$ et ledit troisième signal logique $(S_3)$ et produisant en sortie un signal d'indication d'accord $(I_S)$, le registre étant agencé de manière que le niveau du signal d'indication d'accord corresponde à un accord seulement si le troisième signal logique $(S_3)$ présente un niveau indiquant un accord stable pendant au moins deux périodes successives de la fréquence de référence.

2. Synthétiseur selon la revendication 1 caractérisé en ce que le détecteur de phase comporte une première (21) et une deuxième (22) bascule de détection de type D recevant un niveau logique haut sur leur entrée de donnée (D) et recevant à leur entrée de cadencement (CP) respectivement le signal de fréquence d'accord $(F_T)$ et le signal de fréquence de référence $(F_R)$, la sortie non inverseuse (Q) de la première (21) et de la deuxième (22) bascule de détection délivrant respectivement le premier (PS1) et le deuxième (PS2) signal de phase et l'entrée de remise à zéro (R) de la première (21) et de la deuxième (22) bascule de détection recevant le produit logique du premier (PS1) et du deuxième (PS2) signal de phase.

3. Synthétiseur selon une des revendications 1 ou 2 caractérisé en ce que le registre comporte un diviseur de fréquence (73) dont l'entrée de cadencement (CP) reçoit l'inverse $(\overline{F_R})$ du signal de fréquence de référence $(F_R)$ et produit un signal de cadencement qui est un sous-multiple de la fréquence de référence, lequel attaque l'entrée de cadencement (CP) d'une bascule d'acquisition d'accord de type D (74) dont l'entrée de donnée (D) reçoit un niveau logique bas, dont l'entrée de mise à niveau (S) reçoit le troisième signal logique $(S_3)$ et en ce qu'il comporte une première bascule de confirmation d'accord (75), de type D, dont l'entrée de remise à zéro (R) reçoit le signal de la sortie non-inverseuse $(\overline{Q})$ de la bascule d'acquisition d'accord (74) et dont l'entrée de donnée (D) reçoit le signal de la sortie inverseuse (Q) de la bascule d'acquisition d'accord (74) dont l'entrée de cadencement (CP) reçoit ledit signal de cadencement.

4. Synthétiseur selon la revendication 3 caractérisé en ce que le registre est un registre à décalage qui comporte n bascules de confirmation d'accord (75-78), avec n entier supérieur à 1, remises à zéro par le signal de sortie non-inverseuse (Q) de la bascule d'acquisition d'accord (74) et recevant à leur entrée de cadencement (CP) ledit signal de cadencement, l'entrée de donnée (D) de la $p^{ième}$ bascule de confirmation d'accord recevant le signal de la sortie non-inverseuse (Q) de la $(p-1)^{ième}$ bascule de confirmation d'accord, la sortie non-inverseuse (Q) de la $n^{ième}$ bascule de confirmation d'accord délivrant ledit signal d'accord $(IS = Q_n)$.

## Claims

1. A frequency synthesizer comprising at least an oscillator (1) whose frequency is controlled by a tuning signal and which produces a tuning frequency signal, means (3) for generating a reference frequency signal, a phase detector (4) receiving the tuning frequency signal and the reference frequency signal, a phase-locked loop (5) receiving at its input signals produced by the phase detector and producing at its output said tuning signal, and a tuning indicator device (7) having a tolerance on the phase difference between the tuning frequency signal and the reference frequency signal, characterized in that the phase detector (4) is operated in such a way that it produces at the output a first (PS1) and a second (PS2) phase signal leading and lagging, respectively, the phase between the tuning frequency signal ($F_T$) and the reference frequency signal ($F_R$), the phase-locked loop receiving said first and second phase signals, and in that the tuning indicator device (7) comprises a first logic circuit (31, 33) producing at its output a first logic signal ($S_1$) formed by the logic product of the first phase signal delayed by a predetermined period of time by a first delay circuit (31) and of the first phase signal (PS1), a second logic circuit (32, 34) producing at its output a second logic signal ($S_2$) formed by the logic product of the second phase signal delayed by the same predetermined period of time by a second delay circuit (32) and of the second phase signal (PS2), a third logic circuit (35) producing at its output a third logic signal ($S_3$) formed by the logic sum of the first ($S_1$) and second ($S_2$) logic signals, and a register (72) receiving said reference frequency signal ($F_R$) and said third logic signal ($S_3$) and producing at its output a tuning indication signal ($I_S$), the register being operated in such a manner that the tuning indication signal level corresponds to a tuning only when the third logic signal ($S_3$) has a level indicating a stable tuning during at least two consecutive periods of the reference frequency.

2. A synthesizer as claimed in Claim 1, characterized in that the phase detector comprises a first (21) and a second (22) D-type detection flip-flop receiving a high logic level at their data inputs (D) and the tuning frequency signal ($F_T$) and the reference frequency signal ($F_R$), respectively, at their clock inputs (CP), the non-inverting output Q of the first (21) and the second (22) detection flip-flop supplying the first (PS1) and the second (PS2) phase signal, respectively, and the reset inputs (R) of the first (21) and the second (22) detection flip-flop receiving the logic product of the first (PS1) and the second (PS2) phase signal.

3. A synthesizer as claimed in any one of Claim 1 or 2, characterized in that the register comprises a frequency divider (73) whose clock input (CP) receives the reciprocal version ($F_R$)

of the reference frequency signal ($F_R$) and produces a clock signal which is a sub-multiple of the reference frequency, said clock signal being applied to the clock input (CP) of a D-type tuning acquisition flip-flop (74) whose data input (D) receives a low logic level, whose set input (S) receives the third logic signal (S3), and in that it comprises a first D-type tuning confirmation flip-flop (75) whose reset input (R) receives the signal from the non-inverting output (Q) of the tuning acquisition flip-flop (74) and whose data input (D) receives the signal from the inverting output (Q) of the tuning acquisition flip-flop (74) whose clock input (CP) receives said clock signal.

4. A synthesizer as claimed in Claim 3, characterized in that the register is a shift register which comprises n tuning confirmation flip-flops (75-78), where n is an integer exceeding 1, which are reset by the signal of the non-inverting output (Q) of the tuning acquisition flip-flop (74) and receive said clock signal at their clock inputs (CP), the data input (D) of the $p^{th}$ tuning confirmation flip-flop receiving the signal from the non-inverting output (Q) of the $(p-1)^{th}$ tuning confirmation flip-flop, the non-inverting output (Q) of the $n^{th}$ tuning confirmation flip-flop supplying said tuning signal ($IS = Q_n$).

**Patentansprüche**

1. Frequenzsynthesierer mit mindestens einem Oszillator (1), der in seiner Frequenz durch ein Abstimmsignal gesteuert wird und ein Abstimmfrequenzsignal liefert, mit Mitteln zum Erzeugen eines Bezugsfrequenzsignals (3), mit einem Phasendetektor (4), der das Abstimmfrequenzsignal und das Bezugsfrequenzsignal erhält, mit einer Phasenverriegelungsschleife (5), die am Eingang von dem Phasendetektor erzeugte Signale erhält, und am Ausgang das genannte Abstimmsignal liefert, und mit einer Abstimmanzeigeeinrichtung (7), die eine Toleranz der Phasendifferenz zwischen dem Abstimmfrequenzsignal und dem Bezugsfrequenzsignal angibt, dadurch gekennzeichnet, daß der Phasendetektor (4) derart betrieben wird, daß an seinem Ausgang ein erstes (PS1) und ein zweites (PS2) Phasensignal erzeugt wird, wobei diese Signale gegenüber der Phase zwischen dem Abstimmfrequenzsignal ($F_T$) und dem Bezugsfrequenzsignal ($F_R$) vor- bzw. nacheilen, wobei die Phasenverriegelungsschleife das genannte erste und zweite Phasensignal erhält, und daß die Abstimmanzeige (7) eine erste logische Schaltung (31, 33) aufweist, die an ihrem Ausgang ein erstes logi-

sches Signal ($S_1$) erzeugt, das aus dem logischen Produkt des ersten phasenverzögerten Signal mit einer Phasenverzögerung entsprechend einer von einer ersten Verzögerungsschaltung (31) gegebenen Zeit und des ersten Phasensignals (PS1) gebildet ist, sowie eine zweite logische Schaltung (32, 34), die an ihrem Ausgang ein zweites logisches Signal ($S_2$) erzeugt, das aus dem logischen Produkt des zweiten phasenverzögerten Signals mit einer Phasenverzögerung entsprechend derselben von einer zweiten Verzögerungsschaltung (32) gegebenen Zeit und des zweiten Phasensignals (PS2) gebildet ist, und eine dritte logische Schaltung (35), die an ihrem Ausgang ein drittes logisches Signal ($S_3$) liefert , das durch logische Addierung des ersten ($S_1$) und des zweiten ($S_2$) logischen Signals gebildet ist, und ein Register (72), das das genannte Bezugsfrequenzsignal ($F_R$) und das genannte dritte logische Signal ($S_3$) erhält und am Ausgang ein Abstimmanzeigesignal ($I_S$) liefert, wobei dieses Register derart betrieben wird, daß der Pegel des Abstimmanzeigesignals nur dann mit einer Abstimmung übereinstimmt, wenn das dritte logische Signal ($S_3$) einen Pegel hat, der während mindestens zweier aufeinanderfolgender Perioden der Bezugsfrequenz eine stabile Abstimmung angibt.

2. Synthesierer nach Anspruch 1, dadurch gekennzeichnet, daß der Phasendetektor eine erste (21) und eine zweite (22) D-Typ-Detektions-Flip-Flop-Schaltung aufweist, die an ihrem Dateneingang (D) einen hohen logischen Pegel erhalten und die an ihrem Taktimpulseingang (CP) das Abstimmfrequenzsignal ($F_T$) bzw. das Bezugsfrequenzsignal ($F_R$) erhalten, wobei der nicht-invertierende Ausgang (Q) der ersten (21) und der zweiten (22) Detektions-Flip-Flop-Schaltung das erste (PS1) bzw. das zweite (PS2) Phasensignal liefert, und wobei der Null-Rückstelleingang (R) der ersten (21) und der zweiten (22) Detektions-Flip-Flop-Schaltung das logische Produkt des ersten (PS1) und des zweiten (PS2) Phasensignals erhält.

3. Synthesierer nach Anspruch 1 oder 2, dadurch gekennzeichnet, daß das Register einen Frequenzteiler (73) aufweist, dessen Taktimpulseingang (CD) den invertierten Wert ($\overline{F_R}$) des Bezugsfrequenzsignals ($F_R$) erhält und ein Taktimpulssignal erzeugt, das eine Unterresonanzfrequenz der Bezugsfrequenz ist und dem Taktimpulseingang (CD) einer D-Typ-Abstimm-Zuweisungs-Flip-Flop-Schaltung (74) zugeführt wird, deren Dateneingang (D) einen niedrigen logischen Pegel erhält, deren Pegelsetzeingang (S) das dritte logische Signal ($S_3$) erhält, und daß er eine erste D-Typ-Abstimmbestätigungs-Flip-Flop-Schaltung (75) aufweist, deren Nullrückstelleingang (R) das Signal des nicht-invertierende Ausgangs (Q) der Abstimm-Zuweisungs-Flip-Flop-Schaltung (74) erhält und deren Dateneingang (D) das Signal des invertierenden Ausgangs ($\overline{Q}$) der Abstimm-Zuweisungs-Flip-Flop-Schaltung (74) erhält, deren Taktimpulseingang (CP) das genannte Taktimpulssignal erhält.

4. Synthesierer nach Anspruch 3, dadurch gekennzeichnet, daß das Register ein Schieberegister mit n Abstimm-Zuweisungs-Flip-Flop-Schaltungen (75-78) ist, wobei n eine ganze Zahl über 1 ist, die durch das Signal des nicht-invertierenden Ausgangs (Q) der Abstimm-Zuweisungs-Flip-Flop-Schaltung (74) auf Null rückgestellt werden und an ihrem Taktimpulseingang (CP) das genannte Taktimpulssignal erhalten, wobei der Dateneingang (D) der p. Abstimm-Zuweisungs-Flip-Flop-Schaltung das Signal des nicht-invertierenden Ausgangs (Q) der (p-1). Abstimm-Zuweisungs-Flip-Flop-Schaltung erhält, und wobei der nicht-invertierende Ausgang (Q) der n. Abstimm-Zuweisungs-Flip-Flop-Schaltung das genannte Abstimmsignal ($IS = Q_n$) liefert.

FIG.1

FIG.2a

FIG.2b

FIG.3a

FIG.3b

9